# EUROPEAN PATENT APPLICATION

(11) **EP 2 690 657 A2**
(43) Date of publication of application: **29.01.2014**
(21) Application number: 13176249.4
(22) Date of filing: 12.07.2013
(51) Int. Cl.: H01L 23/525, H01L 23/62, H01L 29/423, H01L 29/417

(54) **Robust fuse-protected transistor**

(30) Priority: 25.07.2012 US 201261675494 P; 08.07.2013 US 201313937173
(71) Applicant: International Rectifier Corporation, El Segundo, CA 90245 (US)
(72) Inventor: Briere, Michael A., Scottsdale, AZ Arizona 85266 (US)
(74) Representative: Dr. Weitzel & Partner

(57) **Abstract**

According to an exemplary implementation, a transistor includes a plurality of drain fingers interdigitated with a plurality of source fingers. The transistor further includes a gate configured to control current conduction between the plurality of drain fingers and the plurality of source fingers. Additionally, the transistor includes a plurality of drain fuses, each being configured to electrically disconnect a drain finger of the plurality of drain fingers from remaining ones of the plurality of drain fingers. At least one of the plurality of drain fuses can electrically couple the drain finger to a common drain pad. The transistor may further include a plurality of source fuses, each being configured to electrically disconnect a source finger of the plurality of source fingers from remaining ones of the plurality of source fingers.

## Description

### BACKGROUND

The present application claims the benefit of and priority to a pending provisional patent application entitled "Robust Fused Transistor Design," Serial Number 61/675,494 filed on July 25, 2012. The disclosure in this pending provisional application is hereby incorporated fully by reference into the present application.

### I. DEFINITION

As used herein, the phrase "group III-V" refers to a compound semiconductor including at least one group III element and at least one group V element. By way of example, a group III-V semiconductor may take the form of a III-Nitride semiconductor. "III-Nitride", or "III-N", refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N(_{1-a-b)}), aluminum indium gallium arsenide phosphide nitride (AlₓIn_{y}Ga(_{1-x-y})AsₐP_{b}N(_{1-a-b)}), for example. III-Nitride also refers generally to any polarity including but not limited to Ga-polar, N-polar, semi-polar, or non-polar crystal orientations. A III-Nitride material may also include either the Wurtzitic, Zincblende, or mixed polytypes, and may include single-crystal, monocrystalline, polycrystalline, or amorphous structures. Gallium nitride or GaN, as used herein, refers to a III-Nitride compound semiconductor wherein the group III element or elements include some or a substantial amount of gallium, but may also include other group III elements in addition to gallium. A group III-V or a GaN transistor may also refer to a composite high voltage enhancement mode transistor that is formed by connecting the group III-V or the GaN transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

### II. BACKGROUND ART

Transistors often have a multi-finger layout where a drain of the transistor includes a plurality of drain fingers and a source of the transistor includes a plurality of source fingers. The plurality of drain fingers is interdigitated with the plurality of source fingers such that the transistor can conduct current between the plurality of drain fingers and the plurality of source fingers. The multi-finger layout can provide the transistor with high current conduction capability and low resistance. As such, the multi-finger layout may be desirable in high frequency and/or high power applications, such as power switching applications.

### SUMMARY

Robust fused transistors substantially as shown in and/or described in connection with at least one of the figures, and as set forth more completely in the claims.

### BRIEF DESCRIPTION OF THE DRAWINGS

Figure 1 illustrates a plan view of a conventional transistor.
Figure 2 illustrates a plan view of an exemplary transistor, in accordance with an implementation of the present disclosure.
Figure 3 illustrates a plan view of an exemplary transistor, in accordance with an implementation of the present disclosure.
Figure 4 illustrates a plan view of an exemplary transistor, in accordance with an implementation of the present disclosure.
Figure 5 illustrates a plan view of an exemplary transistor, in accordance with an implementation of the present disclosure.

### DETAILED DESCRIPTION

The following description contains specific information pertaining to implementations in the present disclosure. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

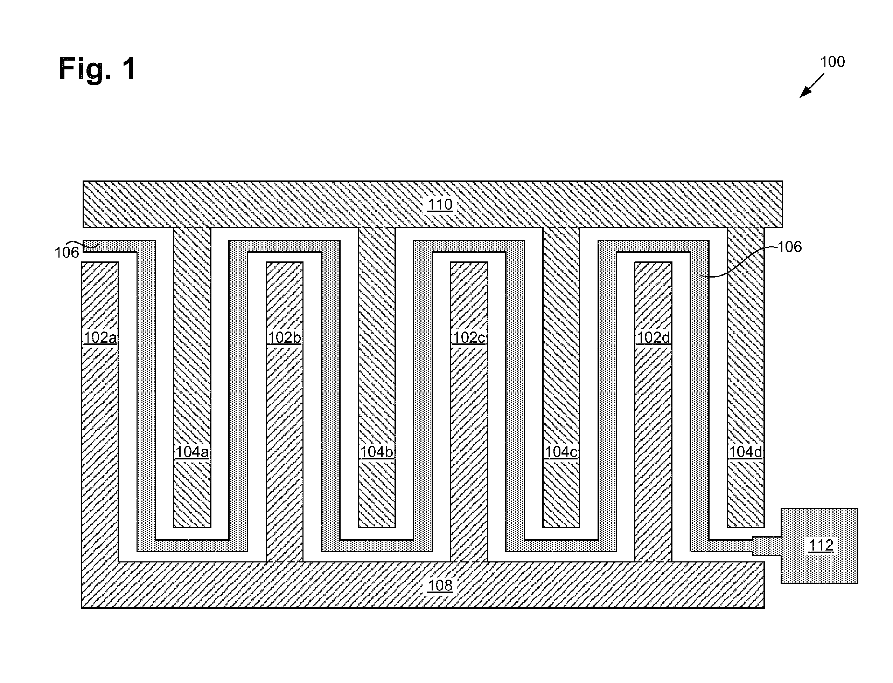

Figure 1 illustrates a plan view of a conventional transistor. Transistor 100 includes a plurality of drain fingers, of which drain fingers 102a, 102b, 102c, and 102d are shown. Transistor 100 also includes a plurality of source fingers, of which source fingers 104a, 104b, 104c, and 104d are shown. Transistor 100 further includes gate 106. Drain fingers 102a, 102b, 102c, and 102d are each electrically coupled to and integrally formed with common drain pad 108. Source fingers 104a, 104b, 104c, and 104d are each electrically coupled to and integrally formed with common source pad 110.

Drain fingers 102a, 102b, 102c, and 102d are interdigitated with source fingers 104a, 104b, 104c, and 104d, such that transistor 100 can conduct current therebetween. Gate 106 controls current conduction between drain fingers 102a, 102b, 102c, and 102d and source fingers 104a, 104b, 104c, and 104d. Gate 106 can be controlled utilizing gate contact 112.

Gate 106 interweaves drain fingers 102a, 102b, 102c, and 102d and source fingers 104a, 104b, 104c, and 104d. However, gate 106 can alternatively include a plurality of gate fingers connected to a common gate pad and may be interdigitated similar to the plurality of drain fingers and the plurality of source fingers using another layer of interconnect (not shown). Herein drain fingers, source fingers, and gate fingers may also be referred to generally as device fingers.

Transistor 100 can include, for example, approximately one hundred or more of the plurality of drain fingers and the plurality of source fingers. Transistor 100 is at risk for catastrophic failure in the event that a short occurs. The short may occur between gate 106 and any of drain fingers 102a, 102b, 102c, and 102d or between gate 106 and any of source fingers 104a, 104b, 104c, and 104d. As one example, the short can be from any of drain fingers 102a, 102b, 102c, and 102d to gate 106 and from gate 106 to any of source fingers 104a, 104b, 104c, and 104d. However, the short may not include gate 106 while still being between any of drain fingers 102a, 102b, 102c, and 102d and any of source fingers 104a, 104b, 104c, and 104d. This may occur, for example, where the short is caused by a failure in one or more interconnect layers of transistor 100.

The short can result in loss of gate control where gate 106 is unable to controllably turn off of transistor 100. This can potentially damage a load or other surrounding circuitry that may be coupled to transistor 100. Also, the loss of gate control can concurrently subject transistor 100 to high voltage and high current over an extended period of time. This can cause transistor 100 to dissipate excessive energy leading to catastrophic failure.

In addition to loss of gate control, a majority of current running through transistor 100 attempts to flow through the short. Thus, an affected device finger may exceed its nominal maximum sustainable current. Furthermore, high power current density at the site of the short may cause destruction of semiconductor material and subsequent shorting and melting of metal forming the affected device finger.

In accordance with implementations of the present disclosure, a transistor includes a plurality of device fuses, each being configured to electrically disconnect a device finger of a plurality of device fingers from remaining ones of the plurality of device fingers. As such, if a short occurs that causes excessive current flow through the device finger, current flow therethrough can be permanently disrupted thereby protecting the transistor and surrounding circuitry. In certain implementations, each of the plurality of device fuses open at approximately two times to approximately ten times the designated maximum saturated current of the device finger.

As an example, a device may have a nominal sustainable current density of the interconnect or metal cross-section allowed by electromigration limits for the device fingers of approximately 1E6 amps per square centimeter. The device may be designed for a nominal drain to source current of approximately 10 amps and a maximum saturated current of approximately 40 amps. If the device has one hundred device fingers, then each device finger would be constructed to allow for a nominal drain to source current of approximately 100 milliamps with a maximum saturated current of approximately 400 milliamps. Thus, the device fuse may be designed to open if current through the device finger exceeds, for example, approximately 0.8 amps to approximately 4 amps. Additionally, the device fuse may be configured to open at a current density of, for example, greater than approximately 8E6 amps per square centimeter of the cross-section of the device fuse.

Including the plurality of device fuses can potentially increase the resistance of the transistor. In some implementations, the transistor is oversized by approximately five percent to approximately ten percent of rated power to account for expected losses due to added resistance from the plurality of device fuses. Oversizing the transistor can also ensure the transistor's power rating can still meet load requirements, even where one or more of affected device fingers are electrically disconnected from the transistor by one or more of the plurality of device fuses.

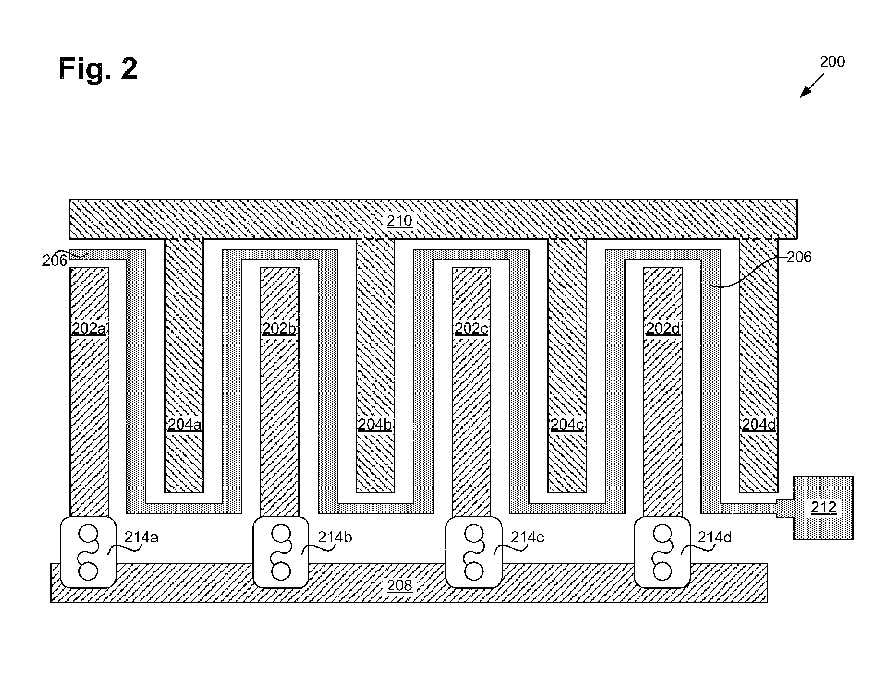

Referring now to Figure 2, Figure 2 illustrates a plan view of an exemplary transistor, in accordance with an implementation of the present disclosure. In Figure 2, transistor 200 includes a plurality of drain fingers, of which drain fingers 202a, 202b, 202c, and 202d are shown. Transistor 200 also includes a plurality of source fingers, of which source fingers 204a, 204b, 204c, and 204d are shown. Transistor 200 further includes gate 206. Drain fingers 202a, 202b, 202c, and 202d are each electrically coupled to common drain pad 208. Source fingers 204a, 204b, 204c, and 104d are each electrically coupled to common source pad 210.

Drain fingers 202a, 202b, 202c, and 202d are interdigitated with source fingers 204a, 204b, 204c, and 204d, such that transistor 200 can conduct current therebetween. Gate 106 is configured to control current conduction between drain fingers 202a, 202b, 202c, and 202d and source fingers 204a, 204b, 204c, and 204d. Gate 206 can be controlled utilizing gate contact 212.

Gate 106 interweaves drain fingers 202a, 202b, 202c, and 202d and source fingers 204a, 204b, 204c, and 204d. However, gate 206 can alternatively include a plurality of gate fingers connected to a common gate pad and may be interdigitated with the plurality of drain fingers and the plurality of source fingers using another layer of interconnect (not shown).

Transistor 200 can have low resistance compared to other transistors that utilize a different device layout. In power switching applications, transistor 200 can be utilized as a power switch that provides power to a load. However, aspects of the present application extend beyond transistors being utilized in power switching application.

Examples of transistor 200 include a group IV transistor, such as a silicon carbide or silicon transistor, or a group III-V transistor (e.g. a III-Nitride transistor), such as a gallium nitride (GaN) transistor. In some implementations, transistor 200 is a high-electron-mobility transistor (HEMT), such a GaN HEMT. Other examples of transistor 200 include various types of metal-oxide-semiconductor field-effect transistors (MOSFETs), junction field-effect-transistors (JFETs), and insulated-gate bipolar transistors (IGBTs).

Transistor 200 also includes a plurality of drain fuses, of which drain fuses 214a, 214b, 214c, and 214d are shown. Drain fuses 214a, 214b, 214c, and 214d each are electrically coupling one of drain fingers 202a, 202b, 202c, and 202d to common drain pad 208 as shown. Drain fuses 214a, 214b, 214c, and 214d are each configured to electrically disconnect an associated one of drain fingers 202a, 202b, 202c, and 202d from remaining ones of drain fingers 202a, 202b, 202c, and 202d. Thus, during a short, the associated one of drain fingers 202a, 202b, 202c, and 202d is electrically disconnected thereby protecting transistor 200 and surrounding circuitry. However, the remaining ones of drain fingers 202a, 202b, 202c, and 202d can remain operational in transistor 200.

By way of example, suppose a short occurs between gate 206 and drain finger 202a. Current flowing through gate 206 and drain finger 202a would exceed the maximum saturated current for both gate 206 and drain finger 202a. Furthermore, the current would exceed the current density of the cross-section of drain fuse 214a required to activate drain fuse 214a, thereby isolating the short between gate 206 and drain finger 202a. However, drain fuses 214b, 214c, and 214d remain closed allowing continued operation of other regions of transistor 200.

Drain fuses 214a, 214b, 214c, and 214d can include at least one metal, metal alloy, or polysilicon. For example, drain fuses 214a, 214b, 214c, and 214d can include aluminum or aluminum alloys. In some implementations, drain fuses 214a, 214b, 214c, and 214d include Titanium Nitride. Drain fuses 214a, 214b, 214c, and 214d can include the same or different materials than drain fingers 202a, 202b, 202c, and 202d and/or common drain pad 208. In some implementations, drain fuses 214a, 214b, 214c, and 214d each include a single layer of metal or metal alloy. Drain fuses 214a, 214b, 214c, and 214d can be formed integrally with drain fingers 202a, 202b, 202c, and 202d and/or common drain pad 208 (e.g. from the same material layer). However, the geometry of drain fuses 214a, 214b, 214c, and 214d may be provided such that during a short, the temperature in the vicinity thereof will exceed that necessary for vaporization of fuse material. The vaporization causes an open circuit to disrupt continued current flow in an associated one of drain fingers 202a, 202b, 202c, and 202d.

In transistor 200, a short may occur between gate 206 and any of drain fingers 202a, 202b, 202c, and 202d or between gate 206 and any of source fingers 204a, 204b, 204c, and 204d. As one example, the short can be from any of drain fingers 202a, 202b, 202c, and 202d to gate 206 and from gate 206 to any of source fingers 204a, 204b, 204c, and 204d. However, the short may not include gate 206 while still being between any of drain fingers 202a, 202b, 202c, and 202d and any of source fingers 204a, 204b, 204c, and 204d. This may occur, for example, where the short is caused by a failure in one or more interconnect layers of transistor 200.

Figure 2 shows an implementation in which the plurality of drain fingers include an associated fuse. However, fuses can similarly be associated with any of the plurality of source fingers, and/or a plurality of gate fingers (not included in transistor 200) in addition to or instead of the plurality of drain fingers. To ensure that a transistor can isolate a short between a gate and a source and/or drain, every device finger may have an associated fuse. A respective fuse may link each device finger to a common pad similar to drain fingers 202a, 202b, 202c, and 202d in Figure 2. However, it is not necessary that every device finger have a respective fuse in all implementations of the present disclosure.

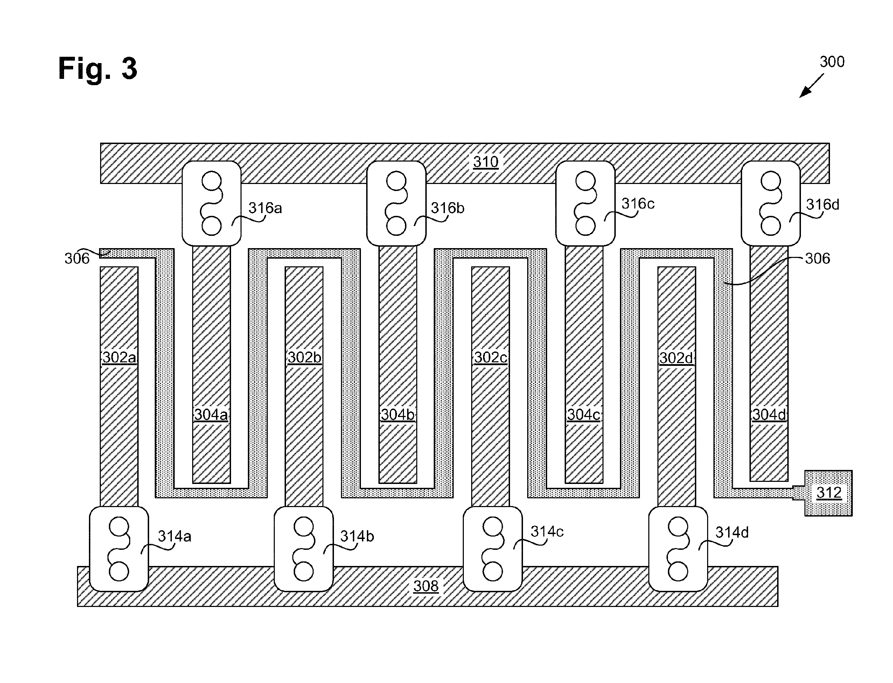

Referring now to Figure 3, Figure 3 illustrates a plan view of an exemplary transistor, in accordance with an implementation of the present disclosure. In Figure 3, transistor 300 includes a plurality of drain fingers, of which drain fingers 302a, 302b, 302c, and 302d are shown. Drain fingers 302a, 302b, 302c, and 302d correspond to drain fingers 202a, 202b, 202c, and 202d in Figure 2. Transistor 300 also includes a plurality of source fingers, of which source fingers 304a, 304b, 304c, and 304d are shown. Transistor 300 further includes gate 306, common drain pad 308, common source pad 310, gate contact 312, and drain fuses 314a, 314b, 314c, and 314d corresponding respectively to gate 206, common drain pad 208, common source pad 210, gate contact 212, and drain fuses 214a, 214b, 214c, and 214d in Figure 2.

Transistor 300 is thus similar to transistor 200. However, transistor 300 also includes a plurality of source fuses, of which source fuses 316a, 316b, 316c, and 316d are shown. Source fuses 316a, 316b, 316c, and 316d each are electrically coupling one of source fingers 304a, 304b, 304c, and 304d to common source pad 310 as shown. Source fuses 316a, 316b, 316c, and 316d are each configured to electrically disconnect an associated one of source fingers 304a, 304b, 304c, and 304d from remaining ones of source fingers 304a, 304b, 304c, and 304d. Thus, during a short, the associated one of source fingers 304a, 304b, 304c, and 304d is electrically disconnected thereby protecting transistor 300 and surrounding circuitry. However, the remaining ones of source fingers 304a, 304b, 304c, and 304d can remain operational in transistor 300.

Source fuses 316a, 316b, 316c, and 316d can be similar to drain fuses 214a, 214b, 214c, and 214d of transistor 200 in terms of potential structure, materials, and operation and therefore are not described in detail. However, source fingers 304a, 304b, 304c, and 304d may have different maximum saturated current characteristics than drain fingers 202a, 202b, 202c, and 202d, which may be reflected in the configuration of source fuses 316a, 316b, 316c, and 316d.

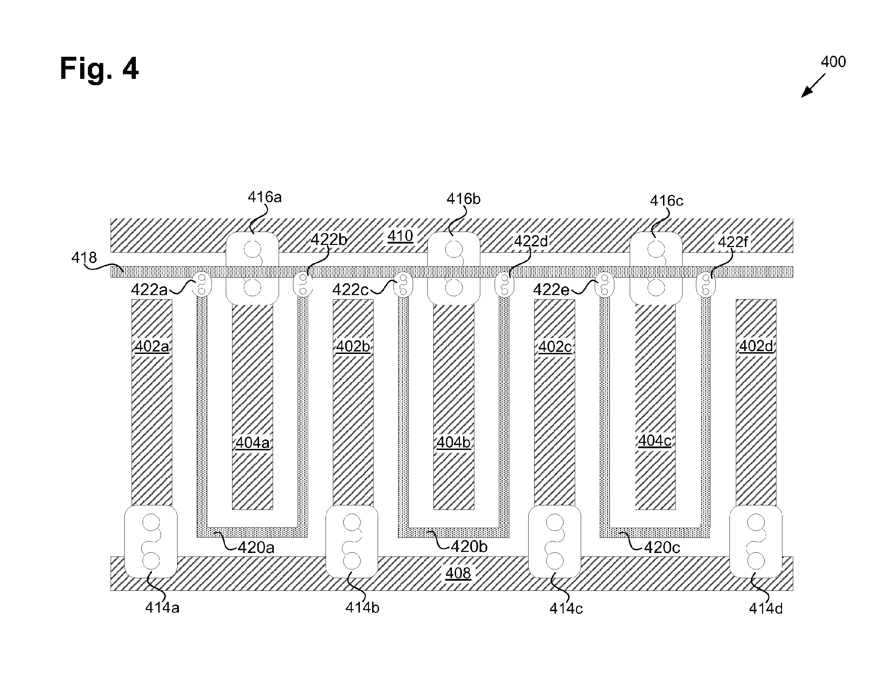

Referring now to Figure 4, Figure 4 illustrates a plan view of an exemplary transistor, in accordance with an implementation of the present disclosure. In Figure 4, transistor 400 includes a plurality of drain fingers, of which drain fingers 402a, 402b, 402c, and 402d are shown. Drain fingers 402a, 402b, 402c, and 402d correspond to drain fingers 302a, 302b, 302c, and 302d in Figure 3. Transistor 400 also includes a plurality of source fingers, of which source fingers 404a, 404b, and 404c are shown. Source fingers 404a, 404b, and 404c correspond to source fingers 304a, 304b, and 304c in Figure 3. Transistor 400 further includes common drain pad 408, common source pad 410, drain fuses 414a, 414b, 414c, and 414d, and source fuses 416a, 416b, and 416c corresponding respectively common drain pad 308, common source pad 310, drain fuses 314a, 314b, 314c, and 314d, and source fuses 316a, 316b, and 316c in Figure 3.

Transistor 400 is thus similar to transistor 300. However, instead of gate 306, transistor 400 includes a plurality of gate fingers, of which gate fingers 420a, 420b, and 420c are shown. Gate fingers 420a, 420b, and 420c are configured to control current conduction between drain fingers 402a, 402b, 402c, and 402d and source fingers 404a, 404b, and 404c. In the implementation shown, gate fingers 420a, 420b, and 420c are each U-shaped and surround a respective one of source fingers 404a, 404b, and 404c. However, gate fingers 420a, 420b, and 420c may each alternatively surround any or all of drain fingers 402a, 402b, 402c, and 402d.

Gate fingers 420a, 420b, and 420c are each electrically coupled to common gate pad 418. Gate fuses 422a and 422b are electrically coupling gate finger 420a to common gate pad 418 at respective ends of gate finger 420a. Also, gate fuses 422c and 422d are electrically coupling gate finger 420b to common gate pad 418 at respective ends of gate finger 420b. Similarly, gate fuses 422e and 422f are electrically coupling gate finger 420c to common gate pad 418 at respective ends of gate finger 420c. While each of gate fingers 420a, 420b, and 420c is electrically coupled to common gate pad 418 by two gate fuses, in other implementations, only one gate fuse may be employed.

Gate fuses 422a, 422b, 422c, 422d, 422e, and 422f are configured to electrically disconnect an associated one of gate fingers 420a, 420b, and 420c from remaining ones of gate fingers 420a, 420b, and 420c. During a short, the associated one of gate fingers 420a, 420b, and 420c is electrically disconnected thereby protecting transistor 400 and surrounding circuitry. However, the remaining ones of gate fingers 420a, 420b, and 420c can remain operational in transistor 400.

Gate fuses 422a, 422b, 422c, 422d, 422e, and 422f can be similar to drain fuses 314a, 314b, 314c, and 314d of transistor 300 in terms of potential structure, materials, and operation and therefore are not described in detail. However, gate fingers 420a, 420b, and 420c may have different maximum saturated current characteristics than drain fingers 202a, 202b, 202c, and 202d, which may be reflected in the configuration of gate fuses 422a, 422b, 422c, 422d, 422e, and 422f.

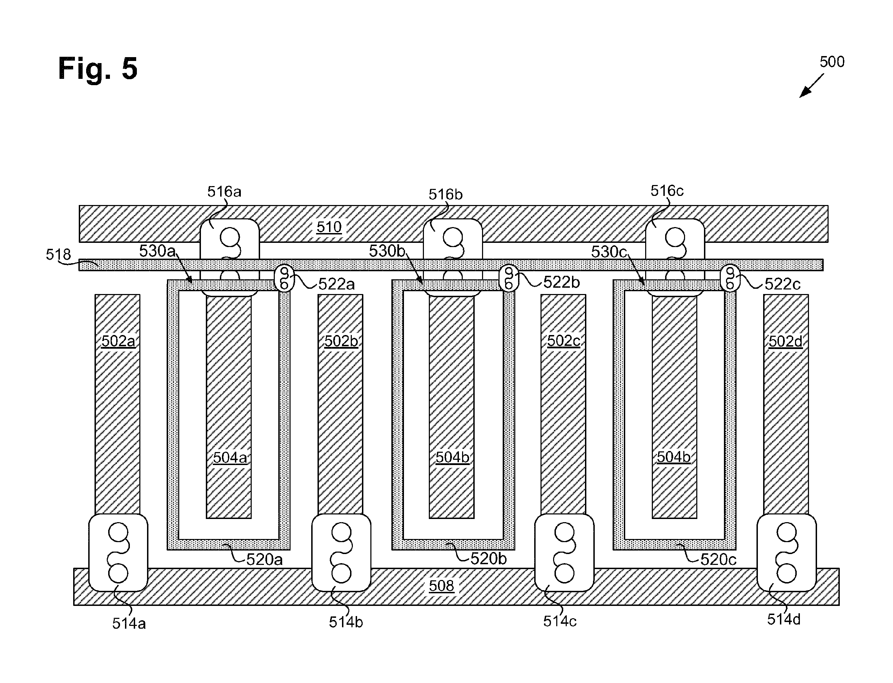

It is noted that transistor 400 can include gate fuses 422a, 422b, 422c, 422d, 422e, and 422f without including source and/or drain fuses. Furthermore, in various implementations, the gate fingers and gate fuses can be configured and structured differently from those in transistor 400. Another such example is provided below with respect to Figure 5.

Referring now to Figure 5, Figure 5 illustrates a plan view of an exemplary transistor, in accordance with an implementation of the present disclosure. In Figure 5, transistor 500 includes a plurality of drain fingers, of which drain fingers 502a, 502b, 502c, and 502d are shown. Drain fingers 502a, 502b, 502c, and 502d correspond to drain fingers 402a, 402b, 402c, and 402d in Figure 4. Transistor 500 also includes a plurality of source fingers, of which source fingers 504a, 504b, and 504c are shown. Source fingers 504a, 504b, and 504c correspond to source fingers 404a, 404b, and 404c in Figure 4. Transistor 500 further includes common drain pad 508, common source pad 510, common gate pad 518, drain fuses 514a, 514b, 514c, and 514d, and source fuses 516a, 516b, and 516c corresponding respectively common drain pad 408, common source pad 410, common gate pad 418, drain fuses 414a, 414b, 414c, and 414d, and source fuses 416a, 416b, and 416c in Figure 4.

Transistor 500 is thus similar to transistor 400. However, in transistor 500, each of gate fingers 520a, 520b, and 520c includes a respective connecting portion. The respective connecting portion can be over or under a respective one of source fingers 504a, 504b, and 504c. As shown, gate fingers 520a, 520b, and 520c include connecting portions 530a, 530b, and 530c respectively. Connecting portions 530a, 530b, and 530c can be situated on dielectric material to insulate gate fingers 520a, 520b, and 520c from source fingers 504a, 504b, and 504c and/or source fuses 516a, 516b, and 516c.

Transistor 500 also includes gate fuses 522a, 522b, and 522c, which are adjacent to respective ones of connecting portions 530a, 530b, and 530c. While each of gate fingers 520a, 520b, and 520c are shown as being electrically coupled to common gate pad 518 by a single gate fuse, two or more gate fuses may be employed similar to gate fingers 420a, 420b, and 420c in Figure 4. Gate fuses 522a, 522b, and 522c can be similar to gate fuses 422a, 422b, 422c, 422d, 422e, and 422f of transistor 400 in terms of potential structure, materials, and operation and therefore are not described in detail. However, gate fingers 520a, 520b, and 520c may have different maximum saturated current characteristics than gate fingers 420a, 420b, and 420c, which may be reflected in the configuration of gate fuses 522a, 522b, and 522c.

It may be desirable to isolate the drain, source, and/or gate fuses (i.e. device fuses) described above from other device constituents under and/or around the device fuses to ensure disruption of current flow to an affected device finger and surrounding device material. As such, in some implementations, dielectric material is situated under and/or around each of the device fuses.

Furthermore, the device fuses should be capable of expanding, vaporizing, and physically disconnecting a device finger from other device fingers and/or a common device pad. Thus, in the implementations shown, an area is included allowing for expansion and vaporization of the device fuse (e.g. a drain fuse) so as to electrically disconnect the device finger from the common device pad. The area may be at least partially be above the device fuse, but can also be at least partially at one or more sides or below the device fuse. In some implementations, the area is formed in one or more dielectric layers, such as one or more inter-metal dielectric layers that separate multiple levels of metallization. The area can also be formed in protective material or other capping material.

In some implementations, a capping material is provided that is be configured to protect the device fuse from oxidation or other corrosion (i.e. passivate the device fuse), or for other purposes. The capping material should be configured such that the device fuse can still sufficiently expand and vaporize into the aforementioned area during a short. By way of example, the capping material may be situated over the drain fuse.

Thus, as described above with respect to Figures 2, 3, 4, and 5, in accordance with implementations of the present disclosure, a transistor includes a plurality of device fuses, each being configured to electrically disconnect a device finger of a plurality of device fingers from remaining ones of the plurality of device fingers. As such, if a short occurs that causes excessive current flow through the device finger, current flow therethrough can be permanently disrupted thereby protecting the transistor and surrounding circuitry.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described above, but many rearrangements, modifications, and substitutions are possible without departing from the scope of the present disclosure.

## Claims

1. A transistor comprising:
a plurality of drain fingers interdigitated with a plurality of source fingers;
a gate configured to control current conduction between said plurality of drain fingers and said plurality of source fingers;
a plurality of drain fuses, each being configured to electrically disconnect a drain finger of said plurality of drain fingers from remaining ones of said plurality of drain fingers.

2. The transistor of claim 1, wherein at least one of said plurality of drain fuses electrically couples said drain finger to a common drain pad.

3. The transistor of claim 1 comprising a plurality of source fuses, each being configured to electrically disconnect a source finger of said plurality of source fingers from remaining ones of said plurality of source fingers.

4. The transistor of claim 1 comprising a plurality of source fuses, each electrically coupling a source finger of said plurality of source fingers to a common source pad.

5. The transistor of claim 1, wherein said transistor is a high-electron-mobility transistor (HEMT).

6. The transistor of claim 1, wherein said transistor is a gallium nitride (GaN) transistor.

7. The transistor of claim 1, wherein said transistor is a group III-V transistor.

8. A transistor comprising:
a plurality of drain fingers interdigitated with a plurality of source fingers;
a plurality of gate fingers configured to control current conduction between said plurality of drain fingers and said plurality of source fingers;
a plurality of gate fuses, each being configured to electrically disconnect a gate finger of said plurality of gate fingers from remaining ones of said plurality of gate fingers.

9. The transistor of claim 8 comprising a plurality of drain fuses, each being configured to electrically disconnect a drain finger of said plurality of drain fingers from remaining ones of said plurality of drain fingers.

10. The transistor of claim 8 comprising a plurality of source fuses, each being configured to electrically disconnect a source finger of said plurality of source fingers from remaining ones of said plurality of source fingers.

11. The transistor of claim 8, wherein said transistor is a high-electron-mobility transistor (HEMT).

12. The transistor of claim 8, wherein said transistor is a gallium nitride (GaN) transistor.

13. The transistor of claim 8, wherein said plurality of gate fingers are each electrically coupled to and situated between first and second common gate pad portions.

14. A transistor comprising:
a plurality of drain fingers interdigitated with a plurality of source fingers;
a gate configured to control current conduction between said plurality of drain fingers and said plurality of source fingers;
a plurality of drain fuses, each electrically coupling a drain finger of said plurality of drain fingers to a common drain pad.

15. The transistor of claim 14 comprising a plurality of source fuses, each electrically coupling a source finger of said plurality of source fingers to a common source pad.
